Europäisches Patentamt

European Patent Office

Office européen des brevets

(11) Numéro de publication : **0 678 753 A1**

# (12) DEMANDE DE BREVET EUROPEEN

(21) Numéro de dépôt : **95400869.4**

(22) Date de dépôt : **19.04.95**

(51) Int. Cl.$^6$ : **G01R 31/36**

(30) Priorité : **21.04.94 FR 9404807**

(43) Date de publication de la demande :
**25.10.95 Bulletin 95/43**

(84) Etats contractants désignés :
**DE ES GB IT**

(71) Demandeur : **SAFT**
**156, avenue de Metz**
**F-93230 Romainville (FR)**

(72) Inventeur : **Perelle, Michel**
**18, rue de la Chanterie**
**F-37210 Parcay-Meslay (FR)**

(74) Mandataire : **Schaub, Bernard et al**
**c/o SOSPI**
**14-16 rue de la Baume**
**F-75008 Paris (FR)**

(54) **Circuit de mesure pour cellules électriques montées en série.**

(57) Circuit incorporant un transducteur de mesure (5), commun, et des interfaces de mesure individuelles (3) pour les cellules. Ces interfaces comportent chacune un générateur (4) déterminant un signal de mesure relatif à une caractéristique de cellule, et elles disposent chacune d'une sortie de signal de mesure (M) reliée au transducteur de mesure du circuit, via une liaison monofilaire commune. Chaque interface comporte deux ports (E/S, S/E) alternativement exploitables l'un pour l'entrée des impulsions de commande transmises à l'interface, l'autre pour la sortie de telles impulsions préalablement reçues et des moyens pour forcer l'émission d'un signal, via la sortie de signal de mesure à destination du transducteur de mesure (5) du circuit, à détection d'un franchissement de seuil par un élément de mesure surveillant une caractéristique de la cellule auquel l'interface est affectée.

FIG.1

L'invention concerne un circuit de mesure pour ensemble modulaire composé de cellules électriques raccordées en série.

L'exploitation de certains ensembles électriques modulaires composés de cellules électriquement montés en série est susceptible d'être nettement optimisée, notamment lorsque le nombre des cellules est relativement grand, s'il est possible de contrôler facilement le fonctionnement de chacune des cellules et par conséquent s'il est possible d'effectuer des mesures par cellule ou à défaut par petit groupe de cellules pour un même ensemble. Tel peut être le cas par exemple pour des ensembles modulaires respectivement de type batterie d'accumulateur, supercondensateur, superconvertisseur ou autre qui sont individuellement et modulairement composés de cellules dont on peut souhaiter contrôler le fonctionnement individuel au niveau d'une logique de supervision.

Or la réalisation d'un circuit apte à réaliser de telles mesures, par exemple des mesures de tension électrique cellule par cellule, qui peut paraître simple en son principe se complique, en fait, dès que le nombre de d'éléments devient grand. Le nombre élevé de fils de mesure alors impliqués conduit généralement à des réalisations relativement lourdes impliquant la mise en place de moyens de commutation nécessitant un nombre élevé d'unités commutantes qui, notamment si ces moyens sont de type électromagnétique, ont conduit à ce que ces circuits ne soient que peu exploités, et seulement le plus souvent pour des réalisations particulières où ils sont pratiquement inévitables.

L'invention propose donc un perfectionnement à un circuit de mesure pour ensemble modulaire de cellules électriquement montées en série et constituées chacune d'un ou de plusieurs éléments producteurs, accumulateurs ou convertisseurs d'énergie électrique. Le circuit de mesure incorpore un transducteur de mesure, commun, et des interfaces de mesure individuelles pour les cellules. Les interfaces comportent chacune au moins un générateur déterminant un signal de mesure à partir d'une caractéristique évolutive de la cellule à laquelle l'interface considérée est affectée. Elles disposent chacune d'une sortie de signal de mesure reliée au transducteur de mesure, via une liaison monofilaire commune à toutes. Chaque interface transmet vers le transducteur de mesure, commun, à réception d'une première impulsion de commande, le signal de mesure produit par son générateur et elle retransmet vers une interface suivante toute impulsion de commande reçue avant la fin d'un délai limité déterminé, après une impulsion de commande immédiatement précédente.

Selon une caractéristique de l'invention, chaque interface comporte deux ports alternativement exploitables l'un pour l'entrée des impulsions de commande transmises à l'interface et l'autre pour la sortie de telles impulsions préalablement reçues, le port d'entrée choisi pour un nouveau train d'impulsions de commande étant celui de ces ports qui reçoit la première impulsion du train.

Selon une autre caractéristique de l'invention, le générateur de signal de mesure d'au moins une interface comporte des moyens pour forcer, à tout moment, l'émission d'un signal prioritaire, via la sortie de mesure qui le dessert, à destination du transducteur de mesure du circuit, à détection d'un événement particulier déterminé par un élément de mesure surveillant une caractéristique de la cellule auquel l'interface considérée est affectée.

L'invention, ses caractéristiques et ses avantages sont précisés dans la description qui suit en liaison avec les figures évoquées ci-dessous.

La figure 1 présente un schéma de principe d'un circuit de mesure pour ensemble électrique modulaire.

La figure 2 présente le schéma électrique d'un exemple de réalisation d'une interface individuelle de cellule pour circuit de mesure selon l'invention.

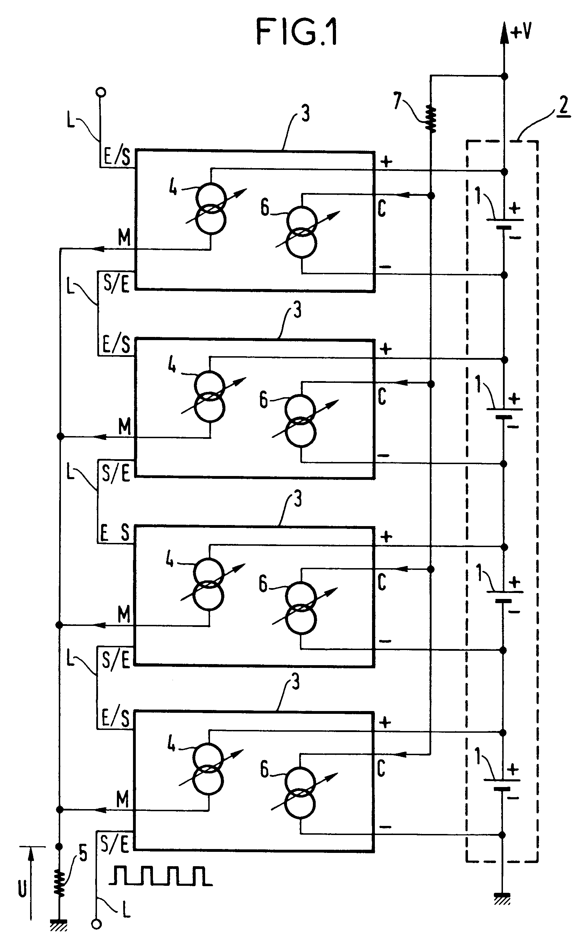

Comme symbolisé en figure 1, le circuit de mesure selon l'invention est destiné à être associé à un ensemble électrique modulaire composé d'une pluralité de cellules 1 connectées en série au niveau des bornes de transmission d'énergie qu'elles comportent, chaque cellule étant classiquement supposée disposant de deux bornes référencées "+" et "-". L'ensemble 2 est supposé constitué par des cellules 1 composées chacune d'un ou de plusieurs éléments qui sont par exemple producteurs, accumulateurs ou convertisseurs d'énergie électrique. Le circuit de mesure est destiné à permettre de collecter des informations relatives au fonctionnement des cellules, en particulier au niveau individuel.

Le circuit de mesure schématisé en figure 1 permet par exemple de déterminer la valeur de la tension continue présente aux bornes de chacune des cellules 1 d'un ensemble électrique modulaire 2 constitué par des éléments ou blocs d'éléments d'une alimentation électrique de type batterie d'accumulateur. Les cellules de l'ensemble sont connectées en série dans cet ensemble au niveau de leurs bornes de transmission d'énergie, chaque cellule étant identiquement constituée d'un ou de plusieurs éléments et comportant deux bornes de transmission d'énergie "+" et "-"

Selon l'invention, le circuit comporte des interfaces de mesure individuelles 3 pour chacune des cellules 1 de l'ensemble 2 auquel il est associé. Chaque interface 3 est ici reliée à des bornes de l'une des cellules et comporte un générateur 4 de signal de mesure, commutable. Dans l'exemple présenté l'interface 3 est reliée aux bornes "+" et "-" d'une cellule et comporte un générateur de signal de mesure 4 fournissant un signal en courant. Ce générateur est ici montré inséré entre la borne "+" de la cellule 1 à laquelle il est associé et une borne d'un transducteur de mesure 5.

Ce transducteur 5 est chargé de transformer les signaux de mesure fournis par les générateurs 4 des interfaces 3 en des signaux représentatifs des grandeurs mesurées au niveau des interfaces. Dans l'exemple envisagé plus haut, d'un générateur 4 fournissant un signal de mesure sous la forme d'un courant, il est produit un signal représentatif se présentant par exemple sous la forme d'une tension au niveau du transducteur 5. Cette tension image correspond par exemple à la tension présente aux bornes de la cellule à laquelle est reliée l'interface comportant le générateur 4 considéré. Bien entendu le signal représentatif peut être obtenu sous bien d'autres formes, par exemple sous la forme d'un signal variable en durée en fonction de la mesure faite.

Dans la réalisation ici envisagée, le transducteur 5 est commun, étant exploité en liaison avec toutes les interfaces individuelles 3 du circuit de mesure. Il est relié par une de ses deux bornes à un potentiel de masse commun au circuit de mesure et à l'ensemble formé par les cellules 1 en série et par l'autre de ses bornes à la sortie de mesure M du générateur 4 de chacune des interfaces 3, via une liaison monofilaire commune de transmission des mesures. Le transducteur 5 est supposé associé à une logique de supervision, non représentée, qui est par exemple organisée autour d'un processeur et qui est apte à interpréter les indications relatives au fonctionnement de l'ensemble que le transducteur 5 transmet.

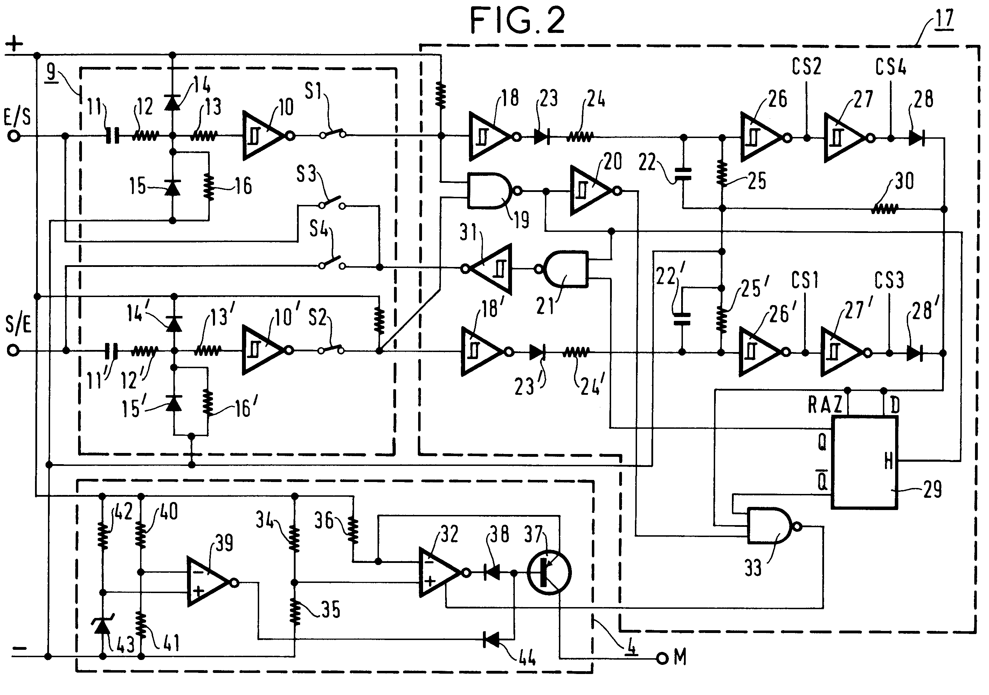

La commutation de chaque générateur de courant 4 est par exemple obtenue sous l'action d'une impulsion de commande qui est ici supposée transmise dans le cadre d'un train d'impulsions de commande TI où chaque impulsion est supposée destinée à une interface déterminée de la suite des interfaces 3 du circuit de mesure supposées reliées entre elles en série. Pour des raisons de sécurité les cellules sont agencées pour pouvoir recevoir les impulsions de commande de l'une ou l'autre des deux extrémités de la suite qu'elles forment, chacune d'elles comportant deux ports d'entrée/sortie, respectivement référencés E/S et S/E, alternativement exploitables l'un en entrée et l'autre en sortie, à la demande et suivant les besoins, ainsi que précisé plus loin en liaison avec la figure 2.

Un train d'impulsions de commande TI, est supposé envoyé par des moyens générateurs, de type usuel, à partir de la logique de supervision, non représentée, et vers l'une ou l'autre des extrémités de la suite composée par les interfaces 3. La transmission des impulsions s'effectue au travers des interfaces successives et par l'intermédiaire des divers éléments de liaison qui constituent la liaison de commande monofilaire L1 entre interfaces successives.

Dans l'exemple plus particulièrement symbolisé sur la figure 1, cet envoi est supposé s'effectuer à destination de l'interface 3 desservant la cellule 1 dont la borne négative "-" est directement reliée au potentiel de masse commun.

Il est prévu que chaque interface prenne en compte pour elle-même la première impulsion d'un train de commande qu'elle reçoit par l'un de ses deux ports E/S et S/E, soit le port S/E dans l'exemple ci-dessus, et transmette les éventuelles impulsions suivantes de ce train à l'autre de ses ports, soit ici E/S, vers le port, soit ici S/E, de l'interface, qui est reliée à elle par un élément de liaison de commande L et qui peut alors être considérée comme située en aval.

Le générateur 4 d'une interface 3 est commuté passant par l'impulsion d'un train de commande qui est prise en compte par cette interface, ceci s'effectuant d'une manière qui sera précisée plus loin. Il fournit alors un signal de mesure au transducteur 5 qui est fonction de la cellule 1 à laquelle est affectée l'interface le comportant. Si le transducteur 5 est une résistance comme supposé plus haut, il apparaît donc une tension aux bornes de cette résistance qui est représentative de la tension présente entre les bornes de la cellule 1 alimentante. Chacune des impulsions successives d'un train de commande TI met temporairement en liaison le générateur 4 d'une des interfaces avec le transducteur 5 dans l'ordre de succession de ces interfaces à partir de celle d'entre elles qui reçoit la première impulsion d'un train ici supposé constitué d'impulsions binaires périodiques. Dans l'exemple envisagé, les paliers de valeur binaire "zéro" des impulsions d'un même train TI déclenchent successivement une mise à l'état passant du générateur 4 de chacune des interfaces 3 raccordées aux cellules 1, à partir de celle de ces interfaces qui reçoit et conserve la première des impulsions des trains de commande, soit celle affectée à la cellule 1 directement reliée au potentiel de masse commun, dans l'exemple déjà envisagé plus haut. Il s'ensuit l'apparition d'un train d'impulsions de tension, aux bornes de la résistance constituant le transducteur 5, où chaque impulsion, ici positive, est représentative de la tension présente entre bornes de la cellule alors mise en circuit avec cette résistance de transducteur par son générateur 4.

Additionnellement, s'il est nécessaire que le courant ponctionné au niveau de chaque cellule de l'ensemble 2 au cours des mesures successives effectuées sous la commande d'un train d'impulsions soit équilibré, il est prévu d'associer un second générateur de courant 6, commutable, dans chaque interface 3 et un élément de compensation commun 7, correspondant au moins approximativement au transducteur 5, dans le circuit de mesure. Cet élément de compensation 7, par exemple de type résistance, est relié à la borne positive "+V" de l'ensemble 2 de cellules 1 ainsi qu'à chacun des seconds générateurs du circuit de mesure par une seconde borne. Chaque second générateur de courant 6 est supposé commuté par la même commande que le générateur 4 associé à lui dans l'interface 3 qui les comporte, il est inséré entre l'élément de compensation 7 commun du circuit de mesure, auquel il est relié par une borne ici référencée C, et la borne "-" de la cellule 1 à laquelle l'interface 3 qui le comporte est affectée.

Ainsi la commande d'une interface 3, affectée à une cellule 1 entraîne un prélèvement d'énergie, éventuellement partagé, au profit du premier générateur de signal de mesure 4 de cette interface sur au moins cette cellule 1, ainsi que sur toute autre cellule 1 de l'ensemble 2 insérée entre le potentiel de masse et ladite cellule 1 à laquelle est affectée l'interface considérée. Simultanément un prélèvement d'énergie, lui aussi éventuellement partagé, est effectué au profit du second générateur de la même interface 3 sur au moins la cellule 1 à laquelle est affectée cette interface et sur toute autre cellule 1 de l'ensemble 2 insérée entre la borne positive "+V" de cet ensemble et ladite cellule 1 à laquelle est affectée l'interface considérée. Ceci conduit donc à une répartition équilibrée des prélèvements sur toutes les cellules de l'ensemble 2, à chaque série de mesures correspondant à un train complet d'impulsions de commande.

Un exemple de réalisation d'une interface de mesure individuelle de cellule pour circuit selon l'invention est présenté en figure 2, les deux ports E/S et S/E de cette interface 3 sont reliés à un circuit d'accès 9 qui permet de recevoir les impulsions de commande parvenant par l'un quelconque des deux ports, afin soit de les traiter localement, de les retransmettre via l'autre de ces ports, comme détaillé plus loin.

Le circuit d'accès 9 comporte deux montages d'entrée-sortie identiques, desservant chacun un des ports E/S, S/E, et des organes de commutation ici symbolisés par quatre contacts, référencés S1 à S4. Ces organes sont supposés commandés par des signaux prélevés à des niveaux respectivement référencés CS1 à CS4, pour des raisons de simplification du schéma, ils sont préférablement réalisés sous forme électronique par exemple sous la forme d'interrupteurs C-MOS. Deux des organes de commutation sont destinés à transmettre les impulsions de commande susceptibles de provenir de l'un des ports desservis, tels ici S1 pour les impulsions provenant du port E/S et S2 pour celles provenant du port S/E. Les deux autres organes de commutation sont destinés à retransmettre les impulsions de commande reçues qui sont destinées à être réémises vers une autre interface, soit via le port E/S pour l'organe S3, soit via le port S/E pour l'organe S4.

Un premier montage d'entrée-sortie du circuit d'accès 9 comporte un inverseur logique 10, de type amplificateur inverseur à seuil. Cet inverseur est attaqué par les impulsions de commande provenant du port E/S au travers d'un condensateur 11 d'élimination de composante continue et d'un groupe de deux résistances 12 et 13 en série. L'inverseur 10 est alimenté entre les bornes "-" et "+" de la cellule, dite associée, à laquelle l'interface est raccordée, ceci n'étant pas montré sur la figure 2. Deux diodes 14 et 15, montées en série entre les bornes "-" et "+" considérées ci-dessus, constituent un montage écrêteur où la cathode de la diode 14 et la cathode de la diode 15 sont reliées au point commun aux résistances 12 et 13. Une résistance 16, de forte valeur, en parallèle à la diode 15, fixe le potentiel en l'absence d'impulsion de commande en provenance du port E/S et complète ce premier montage d'entrée/sortie. Celui-ci est destiné à transmettre les impulsions des trains de commande TI qu'il reçoit à un circuit de commande d'interface 17, via l'organe de commutation S1. Il est aussi destiné à retransmettre, via l'organe de commutation S3 toute impulsion reçue par le circuit de commande 17 en provenance du port S/E qui est destinée à une interface, alors accessible via le port E/S.

Le second montage de sortie que comporte le circuit d'accès 9 a un rôle analogue. Il est destiné à relier le port d'entrée S/E au circuit de commande d'interface 17, via l'organe de commutation S2, comme le réalise le premier montage d'entrée-sortie pour le port d'entrée E/S, via l'organe de commutation S1. Il est donc constitué comme ce premier montage et il comporte en conséquence des composants référencés de 10' à 16' qui correspondent aux composants référencés de 10 à 16 décrits ci-dessus. Il est aussi destiné à retransmettre, via l'organe de commutation S4 toute impulsion reçue par le circuit de commande 17 en provenance du port E/S qui est destinée à une interface, alors accessible via le port S/E.

Le circuit de commande 17 comporte un inverseur logique 18, de type amplificateur inverseur à seuil, et une porte 19, de type NAND, l'une et l'autre susceptibles d'être reliées par une entrée en sortie de l'inverseur 10 du circuit d'accès 9, via l'organe de commutation S1. Il comporte aussi un inverseur 18', de même type que l'inverseur 18, qui est susceptible d'être relié par une entrée en sortie de l'inverseur 10' du circuit d'accès 9, via l'organe de commutation S2, de même qu'une seconde entrée de la porte 19. La sortie de cette dernière attaque notamment un inverseur logique 20, de type amplificateur inverseur à seuil, et une entrée d'une porte 21, dite de contrôle d'accès, qui est de type NAND.

Un condensateur 22 est relié par une première borne en sortie de l'inverseur 18, via une diode 23 et une résistance 24 en série, ainsi que par une seconde borne reliée à la borne "-" de la cellule associée à l'interface de mesure qui le comporte. Ce condensateur se charge dès la première impulsion d'un train de commande TI transmise par l'organe de commutation S1 alors positionné à l'état passant et il se maintient pratiquement chargé pour la durée de ce train. Une résistance 25 montée en parallèle au condensateur 22 permet sa décharge à la fin d'un train.

Le point commun au condensateur 22 et aux résistances 24 et 25 est relié à l'entrée d'un premier inverseur logique 26 en série avec un second inverseur 27 dont la sortie est reliée à l'anode d'une diode 28. Un montage analogue est réalisé à l'aide du condensateur 22', des résistances 24' et 25', des inverseurs 26', 27' et de la diode 28'. Les diodes 28 et 28' et une résistance 30, reliée à la borne "-", sont connectées en un même point pour former un circuit de type OU logique. La sortie de ce circuit commande l'entrée de données D et l'entrée de remise à zéro d'une bascule 29, de type D.

En cas d'absence prolongée d'impulsion reçue, en pratique au-delà d'un laps de temps supérieur à un délai limité déterminé correspondant au temps de décharge du condensateur 22, ce dernier s'est vidé, via la résistance 25. Le signal de sortie de l'inverseur 26 est alors au niveau binaire "un" ce qui positionne l'organe de commutation S2 à l'état passant, alors que le signal de sortie de niveau "zéro" de l'inverseur 27 positionne l'organe de commutation S4 à l'état bloquant. La bascule 29 a alors son entrée de données D et son entrée de remise à zéro RAZ maintenues à "zéro". Le circuit de commande 17 comporte aussi un second montage composé par des composants référencés 18' et de 22' à 28' qui sont agencés comme le sont les composants correspondants référencés 18 et de 22 à 28 de manière à avoir un rôle vis-à-vis des impulsions de commande parvenant éventuellement par le port S/E qui soit identique à celui évoqué ci-dessus pour les impulsions de commande parvenant éventuellement par le port E/S. Ceci se traduit notamment par le fait que, comme précédemment, en cas d'absence prolongée d'impulsion de commande en provenance du port S/E, via l'organe de commutation S2 lui-même positionné à l'état passant en cas d'absence prolongée d'impulsion de commande reçue par le port E/S, le condensateur 22' n'est plus chargé. Le signal de sortie de l'inverseur 26' est alors de niveau binaire "un" et positionne l'organe de commutation S1 à l'état passant, alors que celui de l'inverseur 27' positionne l'organe de commutation S3 à l'état bloquant.

En conséquence, en cas d'absence prolongée d'impulsion de commande parvenant par l'un ou l'autre des ports E/S, S/E, les organes de commutation S1 et S2 sont passants en attente d'une impulsion de commande dont l'arrivée chargera l'un ou l'autre des condensateurs 22, 22'. L'arrivée d'une telle impulsion nouvelle entraîne la rupture temporaire de celle des deux liaisons d'entrée, établies via les organes de commutation S1, S2, qui n'est pas celle par l'intermédiaire de laquelle l'impulsion a été reçue. L'organe de commutation S1 ou S2, correspondant, est alors commandé à l'état bloquant pour un laps de temps qui correspond au moins au temps de décharge du condensateur ayant reçu l'impulsion. Simultanément, il y a mise à l'état passant de celui des deux organes de commutation S3 ou S4 qui est relié à celui des deux ports E/S, S/E par l'intermédiaire duquel l'impulsion de commande reçue n'a pas été transmise. Cette mise à l'état passant commandée par le changement de niveau du signal de sortie de l'un des inverseurs 27 ou 27' entraîne la possibilité d'utilisation en tant que sortie de celui des deux ports E/S, S/E par l'intermédiaire duquel l'impulsion de commande n'a pas été reçue.

L'arrivée d'une première impulsion d'un train de commande TI parvenant au circuit de commande 17 via un port, tel le port E/S, entraîne l'apparition d'un créneau qui est retardé du temps de charge du condensateur 22 en sortie d'inverseur 27. Il y a, en conséquence, application d'un signal de niveau logique 1 à l'entrée D de la bascule 29. L'entrée d'horloge H de la bascule 29 est reliée en sortie de la porte 19 et recopie donc en sortie Q le niveau logique présent à l'entrée D et le niveau logique inverse en sortie $\overline{Q}$. La réception d'une première impulsion d'un train de commande par le circuit de commande 17, via l'organe de commutation S1, entraîne l'application de cette première impulsion à l'entrée d'horloge H de la bascule 29, via la porte 19, alors que l'entrée RAZ de cette bascule est encore au niveau "zéro", ce qui inhibe la bascule et bloque la recopie.

La porte de contrôle 21, de type NAND, est reliée à la sortie de la porte 19 par une première entrée et à la sortie de données Q de la bascule 29 par une seconde entrée, elle est aussi reliée par un inverseur logique 31 à un point commun aux organes de commutation S3 et S4. Elle assure donc la transmission des impulsions qu'elle reçoit de la porte 19, sous le contrôle de la bascule 29, à l'exception de la première impulsion de chaque nouveau train reçu par l'interface qui la comporte, via l'organe de commutation S1, puisque cette porte 19 est alors bloquée par la bascule 29.

Les impulsions de commande transmises par la porte de contrôle 21 sont appliquées au point commun aux organes de commutation S3 et S4 de manière à être transmises par celui de ces organes qui est alors passant, soit par l'organe de commutation S4, lorsque les impulsions de commande proviennent au circuit de commande 17 au travers de l'organe de commutation S1, soit par l'organe de commutation S3, lorsque ces impulsions proviennent au travers de l'organe de commutation S2. Elles sont alors transmises soit par le port S/E vers l'interface voisine reliée à ce port par son propre port E/S, si l'organe de commutation S4 est passant, soit par le port E/S vers l'autre interface voisine reliée à ce port E/S par son propre port S/E, si c'est l'organe S3 qui est alors passant.

La fin d'un créneau en sortie d'inverseur 27, suite à la fin d'un train d'impulsions, entraîne la remise à zéro de la bascule 29, lorsque le condensateur 22 est déchargé, ainsi que le condensateur 22'.

La bascule 29 commande aussi le générateur de signal de mesure 4 de l'interface 3 qui la comporte, ce générateur étant ici constitué au moyen d'un élément, tel qu'un amplificateur de mesure 32. La borne d'alimentation négative de ce dernier est commandée par la sortie $\overline{Q}$ de la bascule 29 via une porte 33, de type NAND.

La porte 33 est reliée par une première entrée à la sortie $\overline{Q}$ de la bascule 29, par une seconde entrée au point commun aux cathodes des diodes 28 et 28' au travers duquel les entrées D et RAZ de la bascule 29 sont commandées et par une troisième entrée à la sortie de l'inverseur 20. Elle commande donc l'alimentation de l'amplificateur de mesure 32 pendant le palier séparant la première impulsion de train de commande, reçu via l'un des ports E/S, S/E, de l'impulsion reçue qui la suit, en agissant au niveau de la borne négative d'alimentation de cet amplificateur.

L'amplificateur de mesure 32 est aussi relié pour son alimentation à la borne "+" de la cellule associée à laquelle est raccordée l'interface qui le comporte. Il a une entrée non-inverseuse reliée au point commun d'un pont diviseur à deux résistances 34, 35 relié entre bornes "+" et "-" de la cellule associée, de manière à prendre en compte la valeur de la tension présente à ce niveau. Il a aussi une entrée inverseuse reliée, d'une part, par une résistance 36 à cette même borne "+" et, d'autre part à l'émetteur d'un transistor 37, de type PNP, dont le collecteur est relié à la sortie monofilaire M par laquelle l'interface 3 est elle-même reliée à la résistance constituant le transducteur 5 commun à toutes les interfaces de cellule, dans l'exemple envisagé ici. L'amplificateur de mesure 32 est agencé pour comparer les tensions appliquées à ses deux entrées.

Lorsqu'il est alimenté, c'est-à-dire lorsqu'une première impulsion est appliquée à l'interface dans le cadre d'un train de commande TI, il commande en conséquence par sa sortie la base du transistor 37, via une diode anti-retour 38, de manière que ce transistor fournisse à la résistance constituant le transducteur 5 un signal de mesure en courant fonction de la tension fournie à l'interface 3 par la cellule 1 associée.

La transmission d'un train d'impulsions de commande par l'une ou l'autre des extrémités de la suite formée par les interfaces de mesure 3 associées aux cellules d'un ensemble à superviser se traduit au niveau du transducteur 5 par l'apparition d'un train d'impulsions de mesure respectivement produites chacune par une interface différente à réception de la première impulsion qui lui est transmise. L'ordre d'arrivée des impulsions de mesure correspond à l'ordre de succession des interfaces à partir de l'extrémité de la suite, que ces interfaces forment, où est appliqué le train d'impulsions de commande ayant servi de déclencheur. Le fait que chaque interface puisse être commandée par deux ports distincts permet de déclencher la production d'impulsions de mesure par cette interface, même si l'un de ces ports n'est plus accessible, en raison d'une défaillance affectant l'un des éléments de la liaison de commande, ou l'une des interfaces, par l'intermédiaire desquels ce port reçoit des impulsions de commande.

Dans une forme de réalisation selon l'invention, il est aussi prévu un second élément pour forcer l'émission d'un signal prioritaire, par exemple à des fins de sécurité, à tout moment, en cas de détection d'un événement particulier déterminé. Ce second élément est par exemple constitué par un amplificateur de mesure 39 inclus dans le générateur 4 afin de détecter toute surtension susceptible d'affecter la cellule associée et d'informer la logique de supervision de l'ensemble surveillé en conséquence. Cet amplificateur 39 a par exemple une entrée inverseuse reliée au point commun d'un pont diviseur, à deux résistances 40, 41, relié entre bornes "+" et "-" de la cellule associée à surveiller et une entrée non-inverseuse raccordée au point commun à, d'une part, une résistance 42 reliée à la borne "+" considérée ci-dessus et, d'autre part, à une référence, ici constituée par diode 43, ici de type Zener, à anode reliée à la borne "-" et cathode reliée au point commun. Si la tension présente entre les bornes "+" et "-" de la cellule surveillée dépasse une valeur fixée qu'impose notamment la diode 43, la sortie de l'amplificateur de mesure 39 qui est positive en condition normale, passe à une valeur nulle et entraîne la conduction du transistor 37, à la base duquel l'amplificateur 39 est relié via une diode anti-retour 44. La conduction du transistor 37 entraîne l'apparition d'un courant au niveau du transducteur 5, alors que par exemple aucune impulsion de commande n'est déclenchée par la logique de supervision. Il est possible de limiter la valeur du courant injecté par le transistor 37, dans ces conditions, en insérant un pont diviseur à deux résistances non représenté entre la borne '+' d'une cellule surveillée et la sortie de l'amplificateur de mesure 39 correspondant et en reliant la cathode de la diode 44 au point commun aux deux résistances de ce pont non figuré.

Il est alors possible de détecter la présence de cellules simultanément en surtension, dès apparition du défaut cause de cette surtension, puisque les générateurs de signaux de mesure 4 des cellules concernées sont alors simultanément actifs et alimentent parallèlement le transducteur 5. Ce dernier est alors traversé par un courant dont la valeur est fonction du nombre de cellules concernées par le défaut ce qui permet de connaître à la logique de supervision de déterminer ce nombre.

Bien entendu, les interfaces du circuit selon l'invention peuvent aisément être adaptées au prix de modifications à portée de l'homme de métier pour permettre d'autres mesures que celle envisagée ici. Il est également possible d'associer des circuits auxiliaires aux interfaces pour permettre la transmission successive par chaque interface d'informations relatives à des mesures de différentes natures, sans sortir du cadre de l'invention.

## Revendications

**1/** Circuit de mesure, pour ensemble modulaire de cellules (1) électriquement montées en série et constituées chacune d'un ou de plusieurs éléments producteurs, accumulateurs ou convertisseurs d'énergie électrique, ledit circuit incorporant un transducteur de mesure (5), commun, et des interfaces de mesure individuelles (3) pour les cellules, interfaces qui comportent chacune au moins un générateur (4) déterminant un signal de mesure à partir d'une caractéristique évolutive de la cellule à laquelle l'interface considérée est affectée, qui disposent chacune d'une sortie de signal de mesure (M) reliée au transducteur de mesure du circuit, via une liaison monofilaire commune à toutes les interfaces, qui transmettent chacune vers ce transducteur, à réception d'une première impulsion de commande, le signal de mesure produit par leur propre générateur et qui retransmettent vers une interface suivante toute impulsion de commande reçue avant la fin d'un délai limité déterminé, après une impulsion de commande immédiatement précédente, ledit circuit étant caractérisé en ce que chaque interface comporte deux ports (E/S, S/E) alternativement exploitables l'un pour l'entrée des impulsions de commande transmises à l'interface et l'autre pour la sortie de telles impulsions préalablement reçues, le port d'entrée choisi pour un nouveau train d'impulsions de commande étant celui de ces ports qui reçoit la première impulsion du train.

**2/** Circuit de mesure, selon la revendication 1, caractérisé en ce que le générateur (4) d'au moins une interface comporte des moyens pour forcer l'émission d'un signal prioritaire, via la sortie de mesure (M) qui le dessert, à destination du transducteur de mesure (5) du circuit, à détection d'un événement particulier déterminé par un élément de mesure (39) surveillant une caractéristique de la cellule auquel l'interface considérée est affectée.

**3/** Circuit de mesure selon la revendication 1, caractérisé en ce que chaque interface de mesure comporte un circuit d'accès (9) à deux ports (E/S, S/E) d'entrée-sortie pour les impulsions de commande, chaque port étant sélectivement relié, d'une part, par un montage d'entrée (10 à 16) à un premier organe de commutation (S1 ou S2) apte à le relier à une entrée d'un circuit de commande d'interface (17), par l'intermédiaire duquel l'émission du générateur de signal de mesure (4) de l'interface est déclenchée, et, d'autre part, à une sortie du circuit de commande d'interface par un second organe de commutation (S3 ou S4) pour la transmission des impulsions de commande reçues par l'interface et à retransmettre vers une interface suivante, les organes de commutation étant commandés par le circuit (17) de commande d'interface de manière que les premiers d'entre eux soient commutés passant en l'absence d'impulsion de commande reçue depuis un laps de temps supérieur audit délai limité déterminé, via l'un ou l'autre des ports de l'interface, la réception d'une impulsion de commande transmise par un de ces ports, via l'un des deux premiers organes de commutation étant exploitée par le circuit de commande pour commuter l'autre de ces premiers organes à l'état bloquant et pour commuter passant celui des seconds organes qui est relié à l'autre port.

**4/** Circuit de mesure selon au moins l'une des revendications 1 à 3, caractérisé en ce qu'au moins l'une des interfaces de mesure comporte un générateur de signal de mesure (4) comportant un premier élément (32) qui prend en compte une première caractéristique évolutive propre à la cellule à laquelle l'interface est associée et qui est connecté à la sortie de mesure (M) de ladite interface pour émettre, sous l'action du circuit de commande de cette interface pour une première impulsion de commande reçue, ainsi qu'un second élément (39) qui prend en compte la détection d'un franchissement de seuil par une caractéristique de la cellule à laquelle l'interface est associée pour se connecter à la sortie de mesure (M) de ladite interface pour émettre dès détection d'un franchissement de seuil.

# FIG.1

FIG.2

EP 0 678 753 A1

Office européen
des brevets

**RAPPORT DE RECHERCHE EUROPEENNE**

Numero de la demande

EP 95 40 0869

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| X | EP-A-0 277 321 (ACCUMULATORENFABRIK SONNENSCHEIN) | 1 | G01R31/36 |
| A | * colonne 3, ligne 6 - ligne 58 * <br> * colonne 4, ligne 1 - ligne 35 * <br> * colonne 6, ligne 11 - ligne 33; figures 1-3,6 * <br> --- | 2-4 | |
| A | 6TH ANNUAL APPLIED POWER ELECTRONICS CONFERENCE AND EXPOSITION (APEC 91), <br> 15 Mars 1991 DALLAS,TEXAS, <br> pages 475-479, <br> NOWOROLSKI ET AL. 'A MICROCOMPUTER-BASED UPS BATTERY MANAGEMENT SYSTEM' <br> * page 476, ligne R - page 477, dernière ligne, alinéa 2; figures 2,3 * <br> --- | 1-4 | |
| A | GB-A-2 216 277 (G.P.B. BEGHELLI) <br> * page 3, ligne 7 - ligne 22; figure 2 * <br> --- | 1-4 | |
| A | EP-A-0 112 242 (EDF) <br> * page 4, ligne 1 - page 7, ligne 4; figure 1 * <br> --- | 1 | **DOMAINES TECHNIQUES RECHERCHES (Int.Cl.6)** |
| A | WO-A-91 17451 (OGBORN) <br> * abrégé; figures 1,4 * <br> ----- | 1-4 | G01R |

Le présent rapport a été établi pour toutes les revendications

| Lieu de la recherche | Date d'achèvement de la recherche | Examinateur |
|---|---|---|
| LA HAYE | 8 Août 1995 | Iwansson, K |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)